# EUROPEAN PATENT SPECIFICATION

(11) **EP 1 851 285 B1**
(45) Date of publication and mention of the grant of the patent: **07.09.2011**
(21) Application number: 06734807.8
(22) Date of filing: 09.02.2006
(51) Int. Cl.: C09K 11/06, H01L 51/30

(54) **PHOTOACTIVE MATERIAL COMPRISING A METAL HYDROXYQUINOLINE COMPLEX**
PHOTOAKTIVES MATERIAL MIT EINEM METALL-HYDROXYCHINOLIN-KOMPLEX
MATERIAU PHOTOACTIF CONTENANT UN COMPLEXE D'HYDROXYQUINOLINE METALLIQUE

(30) Priority: 10.02.2005 US 651590 P
(43) Date of publication of application: 07.11.2007
(73) Proprietor: E.I. DU PONT DE NEMOURS AND COMPANY, Wilmington, DE 19898 (US)
(72) Inventor: WANG, Ying, Wilmington, Delaware 19810 (US)
(74) Representative: Hoffmann, Benjamin
(86) International application number: PCT/US2006/004827
(87) International publication number: WO 2006/086684

(56) References cited:
- WO-A-03/088271
- US-A1- 2002 182 441
- US-A1- 2004 197 601
- US-A1- 2004 247 936

## Description

### FIELD OF THE INVENTION

This invention relates in general to photoactive materials containing metal hydroxyquinoline complexes. The photoactive materials can be used, for example, in electronic devices.

### BACKGROUND INFORMATION

Photoactive materials can be used in a variety of electronic devices, such as light-emitting diodes ("OLED"), that make up OLED displays. In OLEDs, the photoactive material is in a layer which is sandwiched between two electrical contact layers. In an OLED the photoactive layer emits light through the light-transmitting electrical contact layer upon application of a voltage across the electrical contact layers.

It is well known to use organic electroluminescent compounds as photoactive materials in light-emitting diodes. Simple organic molecules, conjugated polymers, and organometallic complexes have been used.

Devices which use photoactive materials, frequently include one or more charge transport layers, which are positioned between the photoactive (e.g., light-emitting) layer and one of the contact layers. A hole transport layer may be positioned between the photoactive layer and the hole-injecting contact layer, also called the anode. An electron transport layer may be positioned between the photoactive layer and the electron-injecting contact layer, also called the cathode.

In many cases, one of the charge transport layers has higher charge mobility than the other. Mobility of the holes and electrons can also be quite different within the photoactive layer. This can result in electron/hole imbalance in the photoactive layer and reduce device efficiency and lifetime. One way to achieve balance in these devices is to use hole and electron transport material with the same high mobility. However, it is not sufficient to simply balance the mobilities of the transport layers. There is also a need for photoactive materials with charge mobilities complementary to the charge mobilities of the charge transport layers in order to obtain devices with improved efficiency.

US 2004/197601 A1 discloses organic light emitting devices (OLEDs) and materials used in such devices. The devices disclosed therein include an anode, a cathode, and a first organic layer disposed between the anode and the cathode. The first organic layer is capable of phosphorescent emissions when a voltage is applied between the anode and the cathode, implying that a photoactive compound is present in this layer. However, US 2004/197601 A1 indicates that a second organic layer disposed between the first organic layer and the cathode is also provided, said second organic layer comprising a metal hydroxyquinolate complex. Therefore, the metal hydroxyquinoline complex is not present in the same layer as the photoactive compound. More specifically, the figures of US 2004/197601 A1 indicate that the OLEDs disclosed therein comprise multiple layers, such that none of the layers comprise all three of a photoactive compound, a metal hydroxyquinoline complex, and a hole transport compound.

US 2004/247936 A1 discloses OLEDs consisting of separate layers wherein the hole transporting material is in a separate and distinct layer from the electron transporting lighting emitting layer. US 2004/247936 A1 does not indicate that the photoactive compound, the electron transporting compound, and hole transporting compound may be combined in a single layer and also does not disclose a composition containing all three of these functional components.

WO 03/088271 A discloses various doped organic transport materials for use in OLEDs. However, WO 03/088271 A indicates that the charge transporting layer can be a hole transporting layer or an electron transporting layer, which may be present in an OLED in combination with a luminescent layer. WO 03/088271 A does not provide a clear and unambiguous disclosure of an OLED having a photoactive compound, a metal hydroxyquinoline complex, and a hole transport compound in the same layer. Nor does it disclose a photoactive composition comprising all three of these functional ingredients.

US 2002/182441 discloses an OLED comprising an aluminium tris(8-hydroxyquinoline) coated cathode, which has cast thereon a single layer comprising a photoactive compound ((4,5-F2ppy)Pt(AcAc)), a hole transport compound (polyvinylcarboxazole (PVK)), and an electron transporting material ((4,biphenyl) (4-tert-butyl) oxidiazole (PPD)). US 2002/182441 indicates that the OLED is comprised of four layers, with the aluminium tris (8-hydroxyquinolate) clearly in a separate layer to the PVK and PVD.

### SUMMARY OF THE INVENTION

Provided are photoactive liquid compositions comprising a photoactive compound, a metal hydroxyquinoline complex, and a hole transport compound.

In one embodiment, the metal hydroxyquinoline complex has Formula I: 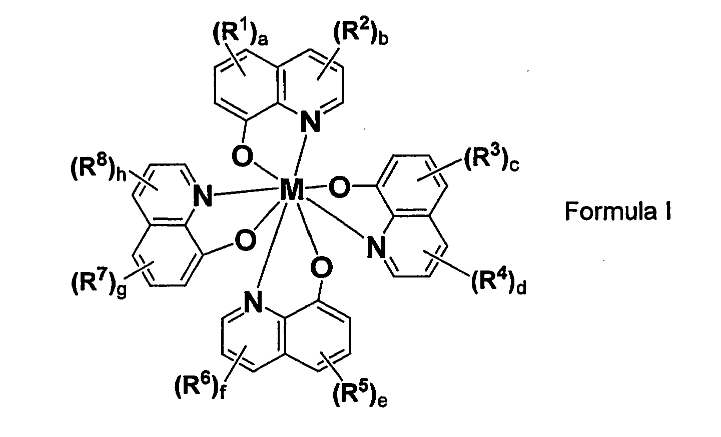 where:
M is selected from Ti, Zr, Hf, Nb, Re, Sn, and Ge;
R¹, R², R³, R⁴, R⁵, R⁶, R⁷, and R⁸ are each independently deuterium, halo, nitrile, alkyl, aryl, alkoxy, aryloxy, fluoroalkyl, fluoroaryl, fluoroalkoxy, fluoroaryloxy, heteroalkyl, heteroaryl, heteroalkoxy, heteroaryloxy, or adjacent substitutents may be joined to form 5- or 6-membered aryl, heteroaryl, or cycloalkyl group; and
a, b, c, d, e, f, g, and h are each independently 0, 1, 2, or 3.

The invention also concerns an organic electronic device comprising an anode, a cathode, and a photoactive layer positioned therebetween, said photoactive layer comprising a photoactive compound, a metal hydroxyquinoline complex, and a hole transport compound.

The foregoing general description and the following detailed description are exemplary and explanatory only and are not restrictive of the invention, as defined in the appended claims.

### BRIEF DESCRIPTION OF THE DRAWINGS

The invention is illustrated by way of example and not limitation in the accompanying figure.

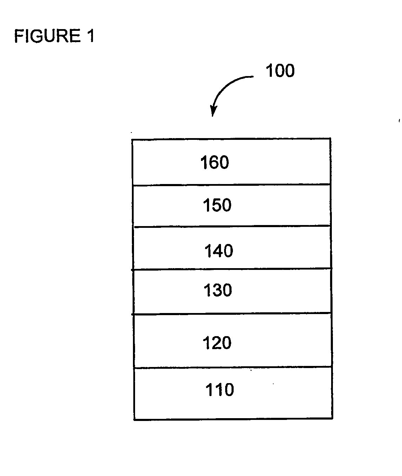

Figure 1: An illustrative example of one new organic electronic device.

### DETAILED DESCRIPTION

Provided are photoactive liquid compositions comprising a photoactive compound, a metal hydroxyquinoline complex, and a hole transport compound. The photoactive compound, the metal hydroxyquinoline complex, and the hole transport compound are referred to herein as "components" of the photoactive composition.

As used herein, the term "photoactive" refers to a material that emits light when activated by an applied voltage (such as in a light emitting diode or electrochemical cell), or responds to radiant energy and generates a signal with or without an applied bias voltage (such as in a photodetector). The term "metal hydroxyquinoline complex" refers to a metal coordinated to at least one ligand which is an hydroxyquinoline or substituted hydroxyquinoline. The metal is coordinated to the nitrogen and the deprotonated oxygen of the hydroxy moiety. The term "hole transport" when referring to a layer, material, member, or structure, is intended to mean such layer, material, member, or structure facilitates migration of positive charges through the thickness of such layer, material, member, or structure with relative efficiency and small loss of charge.

Any organic photoactive compound can be used in the new compositions. Electroluminescent ("EL") compounds can be used, including, but not limited to, small molecule organic fluorescent compounds, fluorescent and phosphorescent metal complexes, conjugated polymers, and mixtures thereof. Examples of fluorescent compounds include, but are not limited to, pyrene, perylene, rubrene, coumarin, derivatives thereof, and mixtures thereof. Examples of metal complexes include, but are not limited to, metal chelated oxinoid compounds, such as tris(8-hydroxyquinolato)aluminum (Alq3); cyclometalated iridium and platinum electroluminescent compounds, such as complexes of iridium with phenylpyridine, phenylquinoline, or phenylpyrimidine ligands as disclosed in Petrov et al., U.S. Patent 6,670,645 and Published PCT Applications WO 03/063555 and WO 2004/016710, and organometallic complexes described in, for example, Published PCT Applications WO 03/008424, WO 03/091688, and WO 03/040257, and mixtures thereof. Electroluminescent emissive layers comprising a charge carrying host material and a metal complex have been described by Thompson et al., in U.S. Patent 6,303,238, and by Burrows and Thompson in published PCT applications WO 00/70655 and WO 01/41512. Examples of conjugated polymers include, but are not limited to poly(phenylenevinylenes), polyfluorenes, poly(spirobifluorenes), polythiophenes, poly(p-phenylenes), copolymers thereof, and mixtures thereof.

In one embodiment of the new photoactive liquid composition, the photoactive compound is an organometallic compound. In one embodiment, the metal is selected from Os, Ir, and Pt. Examples of specific organometallic compounds have been disclosed in, for example, U.S. Patents 6,670,645 and 6,303,238, and in published applications US 2001/0019782, EP 1191612, WO 02/15645, and EP 1191614.

In one embodiment, the photoactive compound is a cyclometallated iridium complex. In one embodiment, the cyclometallated iridium complex has the formula IrLᵢYⱼZₖ. In this formula, L is the same or different at each occurrence and represents a monoanionic bidentate ligand coordinated through a nitrogen on a heteroaromatic ring and a carbon. In one embodiment, L is an arylheterocycle or a heteroarylheterocycle. Examples of L ligands include, but are not limited to, phenylpyridines, phenylquinolines, phenylisoquinolines, thienylpyridines, thienylquinolines, pyrrolylpyridines, pyrollylquinolines, and the like. Ligand L may be substituted or unsubstituted. Substituents include, but are not limited to, deuterium, halo, alkyl, aryl, alkoxy, aryloxy, fluoroalkyl, fluoroaryl, fluoroalkoxy, fluoroaryloxy, heteroalkyl, heteroaryl, heteroalkoxy, heteroaryloxy, or adjacent substitutents may be joined to form 5- or 6-membered aryl, heteroaryl, or cycloalkyl groups.

In the formula of the iridium complex, Y is a monoanionic ligand. Y can be monodentate, bidentate or tridentate. Examples of monodentate Y ligands include, but are not limited to, H- ("hydride") and ligands having C, O or S as coordinating atoms. Coordinating groups include, but are not limited to alkoxide, carboxylate, thiocarboxylate, dithiocarboxylate, sulfonate, thiolate, nitrile, aryl, carbamate, dithiocarbamate, thiocarbazone anions, sulfonamide anions, and the like. In some cases, ligands discussed below as bidentate, such as β-enolates and phosphinoakoxides, can act as monodentate ligands. The monodentate ligand can also be a coordinating anion such as halide, nitrate, sulfate, hexahaloantimonate, and the like. These ligands are generally available commercially.

The bidentate Y ligands generally have N, O, P, or S as coordinating atoms and form 5- or 6-membered rings when coordinated to the metal. Suitable coordinating groups include amino, imino, amido, alkoxide, carboxylate, phosphino, thiolate, and the like. Examples of suitable parent compounds for these ligands include, but are not limited to β-dicarbonyls (β-enolate ligands), and their N and S analogs; amino carboxylic acids (aminocarboxylate ligands); pyridine carboxylic acids (iminocarboxylate ligands); salicylic acid derivatives (salicylate ligands); hydroxyquinolines (hydroxyquinolinate ligands) and their S analogs; and phosphinoalkanols (phosphinoalkoxide ligands).

In the formula of the iridium complex, Z is a neutral ligand, which can be monodentate or bidentate. Examples of such ligands include, but are not limited to, CO, mono- and bidentate phosphine ligands, isonitriles, imines, and diimines.

In the formula of the iridium complex, the subscripts i, j, and k are selected from 0 and integers from 1-3, such that the iridium is hexacoordinate, and the overall complex is uncharged. For example, the formula may be IrL₃; IrL₂Y, where Y is a bidentate ligand; IrL₂Y₂, where both Y ligands are monodentate; IrLY₂, where both Y ligands are bidentate; IrLY₂Z, where one Y ligand is bidentate, one Y ligand is monodentate, and the Z ligand is monodentate; IrLY₂Z, where both Y ligands are monodentate, and the Z ligand is bidentate; or IrLY₂Z₂, where all Y and Z ligands are monodentate.

In one embodiment of the new composition, the metal hydroxyquinoline complex has Formula I: 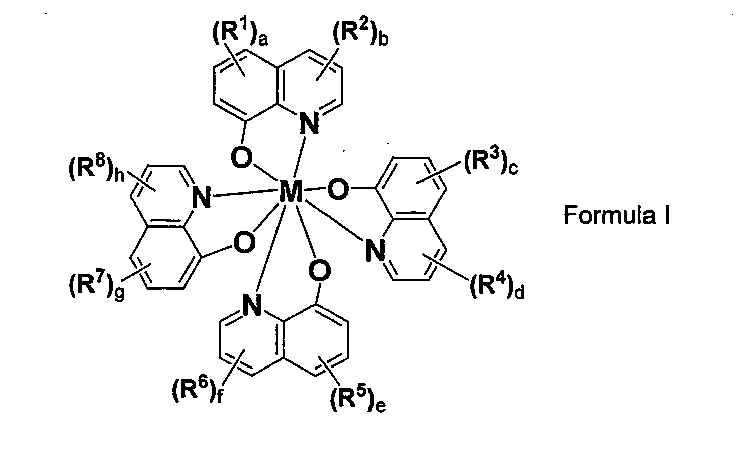 where:
M is selected from Ti, Zr, Hf, Nb, Re, Sn, and Ge;
R¹, R², R³, R⁴, R⁵, R⁶, R⁷, and R⁸ are each independently deuterium, halo, nitrile, alkyl, aryl, alkoxy, aryloxy, fluroalkyl, fluoroaryl, fluoroalkoxy, fluoroaryloxy, heteroalkyl, heteroaryl, heteroalkoxy, heteroaryloxy, or adjacent substitutents may be joined to form 5- or 6-membered aryl, heteroaryl, or cycloalkyl group; and
a, b, c, d, e, f, g, and h are each independently 0, 1, 2, or 3.
The metal hydroxyquinoline complex of Formula I can exist in different isomeric forms. The new photoactive compositions can comprise any one of these isomers, or a combination of two or more isomers.

As used herein, the term "alkyl" includes both branched and straight-chain saturated aliphatic hydrocarbon groups having the specified number of carbon atoms. Unless otherwise indicated, the term is also intended to include cyclic groups. Examples of alkyl groups include methyl, ethyl, propyl, isopropyl, isobutyl, secbutyl, tertbutyl, pentyl, isopentyl cyclopentyl, hexyl, cyclohexyl, isohexyl and the like. The term "alkyl" further includes both substituted and unsubstituted hydrocarbon groups. In some embodiments, the alkyl group may have one substituent ("mono-substituted") or more than one substituent ("poly-substituted"). In certain embodiments alkyl groups have 1 to 20 carbon atoms. In other embodiments, the group has 1 to 6 carbon atoms. The prefix "fluoro" indicates that one or more hydrogen atoms have been replaced with a fluorine atom. The prefix "hetero" indicates that one or more carbon atoms have been replaced with a different atom. In one embodiment, the heteroatoms are selected from nitrogen, oxygen, and sulfur.

The term "aryl" means an aromatic carbocyclic moiety of up to 20 carbon atoms, which may be a single ring (monocyclic) or multiple rings (bicyclic, up to three rings) fused together or linked covalently. Any suitable ring position of the aryl moiety may be covalently linked to the defined chemical structure. Examples of aryl moieties include, but are not limited to, phenyl, 1-naphthyl, 2-naphthyl, dihydronaphthyl, tetrahydronaphthyl, biphenyl. anthryl, phenanthryl, fluorenyl, indanyl, biphenylenyl, acenaphthenyl, acenaphthylenyl, and the like. In some embodiments, aryl groups have 6 to 20 carbon atoms.

The term "alkoxy" means an alkyl group having a terminal oxygen as a point of attachment.

The term "aryloxy" means an aryl group having an oxygen which is not in the carbocyclic ring, which is a point of attachment.

The term "halo" means a halogen atom substituent. In one embodiment, the halogen is fluorine.

The term "nitrile" is intended to mean -CN.

In one embodiment of Formula I, M is Zr. In one embodiment, a through g are 0.

In one embodiment of Formula I, at least one of R¹, R², R³, R⁴, R⁵, R⁶, R⁷, and R⁸ is fluoro or fluoroalkyl. In one embodiment, the fluoroalkyl is CF₃.

In one embodiment of Formula I, at least one of R¹, R², R³, R⁴, R⁵, R⁶, R⁷, and R⁸ is an alkoxy group. In one embodiment, the alkoxy group is -OCH₃.

In one embodiment of Formula I, a = c = f = h = 0, and b= d = e = g = 1.

In one embodiment, the metal hydroxyquinoline complex has Formula II: 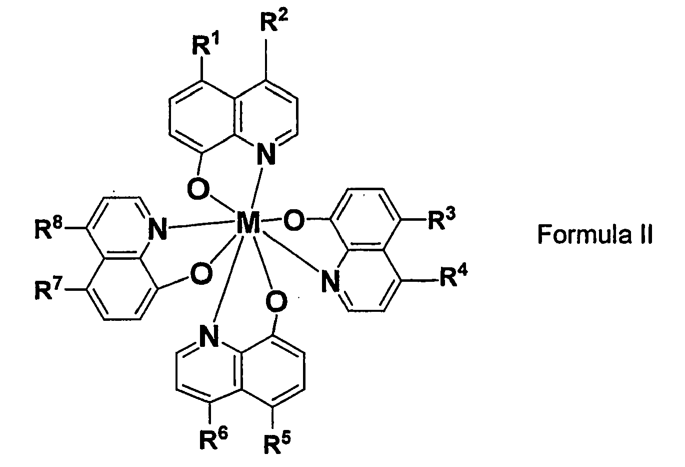 where R¹ through R⁸ are as defined above.

In one embodiment of Formula II, R², R⁴, R⁶ and R⁸ are fluoride or fluoroalkyl groups. In one embodiment of Formula II, R¹, R³, R⁵ and R⁷ are alkoxy groups.

Any organic hole transport compound can be used in the new compositions. Examples of hole transport compounds have been summarized, for example, in Kirk-Othmer Encyclopedia of Chemical Technology, Fourth Edition, Vol. 18, p. 837-860, 1996, by Y. Wang. Both hole transporting small molecules and polymers can be used. Commonly used hole transporting molecules include, but are not limited to: 4,4',4"-tris(N,N-diphenyl-amino)-triphenylamine (TDATA); 4,4',4"-tris(N-3-methylphenyl-N-phenyl-amino)-triphenylamine (mTDATA); N,N'-diphenyl-N,N'-bis(3-methylphenyl)-[1,1'-biphenyl]-4,4'-diamine (TPD); 1,1-bis[(di-4-tolylamino) phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); α-phenyl-4-N,N-diphenylaminostyrene (TPS); p-(diethylamino)benzaldehyde diphenylhydrazone (DEH); triphenylamine (TPA); bis[4-(N,N-diethylamino)-2-methylphenyl](4-methylphenyl)methane (MPMP); 1-phenyl-3-[p-(diethylamino)styryl]-5-[p-(diethylamino)phenyl] pyrazoline (PPR or DEASP); 1,2-trans-bis(9H-carbazol-9-yl)cyclobutane (DCZB); N,N,N',N'-tetrakis(4-methylphenyl)-(1,1'-biphenyl)-4,4'-diamine (TTB); N,N'-bis(naphthalen-1-yl)-N,N'-bis-(phenyl)benzidine (α-NPB); and porphyrinic compounds, such as copper phthalocyanine. Commonly used hole transporting polymers include, but are not limited to, polyvinylcarbazole, (phenylmethyl)polysilane, poly(dioxythiophenes), polyanilines, and polypyrroles.

In one embodiment of the new photoactive liquid composition, the photoactive compound comprises up to 95% by weight, based on the total weight of the composition. In one embodiment, the photoactive compound comprises up to 75% by weight, based on the total weight of the composition. In one embodiment, the photoactive compound comprises less than 50% by weight, based on the total weight of the composition. In one embodiment, the photoactive compound comprises less than 30% by weight, based on the total weight of the composition. In one embodiment, the photoactive compound comprises less than 15% by weight, based on the total weight of the composition. In one embodiment, the photoactive compound comprises less than 20% by volume, based on the total volume of the composition.

In one embodiment of the new photoactive liquid composition, the weight ratio of metal hydroxyquinoline complex to hole transport compound is in the range of 99:1 to 1:99. In one embodiment, the ratio is in the range of 90:10 to 10:90. In one embodiment, the ratio is in the range of 75:25 to 25:75. In one embodiment, the ratio is in the range of 60:40 to 40:60. In one embodiment, the ratio is about 1:1.

The new photoactive compositions can be formed by combining the components using any conventional technique in order to provide a liquid composition. The liquid composition can be formed by adding the components to a liquid medium. The term "liquid composition" is intended to mean a liquid medium in which one or more materials are dissolved to form a solution, a liquid medium in which one or more materials are dispersed to form a dispersion, or a liquid medium in which one or more materials are suspended to form a suspension or an emulsion. The term "liquid medium" is intended to mean a liquid material, including a pure liquid, a combination of liquids, a solution, a dispersion, a suspension, and an emulsion. Liquid medium is used regardless whether one or more solvents are present.

The liquid medium can be any medium which will dissolve or disperse the components of the photoactive composition such that a film can be formed. The organic liquid medium generally comprises an organic liquid. The exact liquid selected will depend on the compounds used in the photoactive composition. Examples of some suitable liquids include, but are not limited to, chlorinated organic liquids, such as chloroform, dichloromethane, and chlorobenzene; alkylated aromatic compounds, such as toluene and xylene; tetrahydrofuran; and N,N-dimethylpyrrolidone. In one embodiment, the liquid medium is an aromatic hydrocarbon solvent. In another embodiment, the liquid medium is selected from toluene, xylene, mesitylene, anisole, chlorobenzene, cyclohexanone, gamma-valerolactone, chloroform, derivatives thereof, and mixtures thereof. The liquid medium can also contain other materials to facilitate film formation, such as processing aids to adjust viscosity, surface tension, and the like.

In one embodiment, the components of the photoactive composition are combined in the vapor phase, by simultaneously vapor depositing the components. In one embodiment, the photoactive compound is vapor deposited with a mixture of the metal hydroxyquinoline complex and the hole transport compound. Any known vapor deposition technique can be used, including physical and chemical vapor deposition.

In one embodiment, the new photoactive liquid composition is in the form of a film. The term "film" is used interchangeably with the term "layer" and refers to a coating covering a desired area. The term is not limited by size. The area can be as large as an entire device or as small as a specific functional area such as the actual visual display, or as small as a single sub-pixel. Layers and films can be formed by any conventional deposition technique, including vapor deposition, liquid deposition (continuous and discontinuous techniques), and thermal transfer. Continuous deposition techniques, inlcude but are not limited to, spin coating, gravure coating, curtain coating, dip coating, slot-die coating, spray coating, and continuous nozzle coating. Discontinuous deposition techniques include, but are not limited to, ink jet printing, gravure printing, and screen printing.

The invention also concerns an organic electronic device that comprises at least one of the aforementioned compositions. The term "organic electronic device" is intended to mean a device including one or more organic semiconductor layers or materials. An organic electronic device includes, but is not limited to: (1) a device that converts electrical energy into radiation (e.g., a light-emitting diode, light emitting diode display, diode laser, or lighting panel), (2) a device that detects a signal using an electronic process (e.g., a photodetector, a photoconductive cell, a photoresistor, a photoswitch, a phototransistor, a phototube, an infrared ("IR") detector, or a biosensors), (3) a device that converts radiation into electrical energy (e.g., a photovoltaic device or solar cell), (4) a device that includes one or more electronic components that include one or more organic semiconductor layers (e.g., a transistor or diode), or any combination of devices in items (1) through (4).

One illustration of an organic electronic device structure is shown in Figure 1. The device **100** has an anode layer **110** and a cathode layer **160,** and a photoactive layer **130** between them. Adjacent to the anode is a layer **120** comprising hole transport material. Adjacent to the cathode is a layer **140** comprising an electron transport material. As an option, devices frequently use another electron transport layer or electron injection layer **150,** next to the cathode.

As used herein, the term "electron transport" when referring to a layer, material, member or structure, means such a layer, material, member or structure that promotes or facilitates migration of electrons through such a layer, material, member or structure into another layer, material, member or structure.

Depending upon the application of the device 100, the photoactive layer **130** can be a light-emitting layer that is activated by an applied voltage (such as in a light-emitting diode or light-emitting electrochemical cell), a layer of material that responds to radiant energy and generates a signal with or without an applied bias voltage (such as in a photodetector). Examples of photodetectors include photoconductive cells, photoresistors, photoswitches, phototransistors, and phototubes, and photovoltaic cells, as these terms are described in Kirk-Othmer Concise Encyclopedia of Chemical Technology, 4th edition, p.1537, (1999).

The photoactive layer **130** comprises the new photoactive composition. More than one photoactive composition can be used. For example, three different composition can be used to form the different colored pixels of the device. A first composition will have a photoactive compound which emits red light; a second composition will have a photoactive compound which emits green light; and a third composition will have a photoactive compound which emits blue light. The term "red light" is intended to mean radiation that has an emission maximum at a wavelength in a range of approximately 600-700 nm. The term "green light" is intended to mean radiation that has an emission maximum at a wavelength in a range of approximately 500-580 nm. The term "blue light" is intended to mean radiation that has an emission maximum at a wavelength in a range of approximately 400-500 nm.

The other layers in the device can be made of any materials which are known to be useful in such layers. The anode **110,** is an electrode that is particularly efficient for injecting positive charge carriers. It can be made of, for example materials containing a metal, mixed metal, alloy, metal oxide or mixed-metal oxide, or it can be a conducting polymer, and mixtures thereof. Suitable metals include the Group 11 metals, the metals in Groups 4, 5, and 6, and the Group 8 10 transition metals. If the anode is to be light-transmitting, mixed-metal oxides of Groups 12, 13 and 14 metals, such as indium-tin-oxide, are generally used. The anode **110** may also comprise an organic material such as polyaniline as described in "Flexible light-emitting diodes made from soluble conducting polymer," Nature vol. 357, pp 477 479 (11 June 1992). At least one of the anode and cathode should be at least partially transparent to allow the generated light to be observed, or the impinging light to reach the photoactive layer.

The hole transport layer, which is a layer that facilitates the migration of negative charges through the layer into another layer of the electronic device, can include any number of materials. Examples of hole transport materials for layer **120** have been summarized for example, in Kirk Othmer Encyclopedia of Chemical Technology, Fourth Edition, Vol. 18, p. 837 860, 1996, by Y. Wang. Both hole transporting molecules and polymers can be used. Commonly used hole transporting molecules include, but are not limited to: 4,4',4"-tris(N,N-diphenyl-amino)-triphenylamine (TDATA); 4,4',4"-tris(N-3-methylphenyl-N-phenyl-amino)-triphenylamine (mTDATA); N,N'-diphenyl-N,N'-bis(3-methylphenyl)-[1,1'-biphenyl]-4,4'-diamine (TPD), 1,1-is[(di-4-tolylamino) phenyl]cyclohexane (TAPC), N,N'-bis(4-methylphenyl)-N,N'-bis(4-ethylphenyl)-[1,1'-(3,3'-dimethyl)biphenyl]-4,4'-diamine (ETPD), tetrakis (3-methylphenyl)-N,N,N',N'-2,5-phenylenediamine (PDA), α-phenyl 4-N,N-diphenylaminostyrene (TPS), p- (diethylamino)benzaldehyde diphenylhydrazone (DEH), triphenylamine (TPA), bis[4 (N,N-diethylamino)-2-methylphenyl](4-methylphenyl)methane (MPMP), 1-phenyl-3-[p-(diethylamino)styryl]-5-[p-(diethylamino)phenyl] pyrazoline (PPR or DEASP), 1,2-trans-bis(9H-carbazol-9-yl)cyclobutane (DCZB), N,N,N',N' tetrakis(4-methylphenyl)-(1,1'-biphenyl)-4,4'-diamine (TTB), N,N'-Bis(naphthalen-1-yl)-N,N'-bis-(phenyl)benzidine (α-NPB), and porphyrinic compounds, such as copper phthalocyanine. Commonly used hole transporting polymers include, but are not limited to, polyvinylcarbazole, (phenylmethyl)polysilane, and polyaniline. It is also possible to obtain hole transporting polymers by doping hole transporting molecules such as those mentioned above into polymers such as polystyrene and polycarbonate.

Electron transport materials which can be used in the electron transport layer **140** and/or the optional layer **150** may optionally include a polymer, such as a polyfluorene or a polythiophene. Suitable electron transport materials for layer **140** or layer **150** include metal chelated oxinoid compounds, such as tris(8-hydroxyquinolato)aluminum (Alq3); and azole compounds such as 2- (4-biphenylyl)-5-(4-t-butylphenyl)-1,3,4-oxadiazole (PBD), 3-(4-biphenylyl)-4-phenyl-5-(4-t-butylphenyl)-1,2,4-triazole (TAZ), and 1,3,5-tri(phenyl-2-benzimidazole)benzene (TPBI); quinoxaline derivatives such as 2,3-bis(4-fluorophenyl)quinoxaline; phenanthrolines such as 4,7-diphenyl-1,10-phenanthroline (DPA) and 2,9-dimethyl-4,7-diphenyl-1,10-phenanthroline (DDPA); and mixtures thereof.

In one embodiment, the electron transport layer **140** comprises a metal hydroxyquinoline compound of Formula I. In one embodiment, the metal is zirconium. In one embodiment, the compound is *tetrakis*-(8-hydroxyquinolinato)zirconium (IV).

The cathode **160,** is an electrode that is particularly efficient for injecting electrons or negative charge carriers. The cathode can be any metal or nonmetal having a lower work function than the anode. Materials for the cathode can be selected from alkali metals of Group 1 (e.g., Li, Cs), the Group 2 (alkaline earth) metals, the Group 12 metals, including the rare earth elements and lanthanides, and the actinides. Materials such as aluminum, indium, calcium, barium, samarium and magnesium, as well as combinations, can be used. Li-containing organometallic compounds, LiF, and Li₂O can also be deposited between the organic layer and the cathode layer to lower the operating voltage.

It is known to have other layers in organic electronic devices. For example, there can be a layer (not shown) between the anode **110** and hole transport layer **120** to facilitate positive charge transport and/or bandgap matching of the layers, or to function as a protective layer. Layers that are known in the art can be used. In addition, any of the above-described layers can be made of two or more layers. Alternatively, some or all of anode layer **110,** the hole transport layer **120,** the electron transport layers **140** and **150,** and cathode layer **160,** may be surface treated to increase charge carrier transport efficiency. The choice of materials for each of the component layers is preferably determined by balancing the goals of providing a device with high device efficiency with device operational lifetime.

In one embodiment, the different layers have the following range of thicknesses: anode 110, 500-5000 A, in one embodiment 1000-2000 A; hole transport layer 120, 50-2000 A, in one embodiment 200-1000 A; photoactive layer 130, 10-2000 A, in one, embodiment 100-1000Å; layers 140 and 150, 50-2000 Å, in one embodiment 100-1000 Å; cathode 160, 200-10000 Å, in one embodiment 300-5000 Å. The location of the electron-hole recombination zone in the device, and thus the emission spectrum of the device, can be affected by the relative thickness of each layer. Thus the thickness of the electron-transport layer should be chosen so that the electron-hole recombination zone is in the light-emitting layer. The desired ratio of layer thicknesses will depend on the exact nature of the materials used.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

As used herein, the phrase "X is selected from A, B, and C" is equivalent to the phrase "X is selected from the group consisting of A, B, and C", and is intended to mean that X is A, or X is B, X is C, X is A + B, X is B + C, X is A + C, or X is A + B + C. The phrase "X is selected from 1 through n" is intended to mean that X is 1, or X is 2,...or X is n.

Also, use of "a" or "an" are employed to describe elements and components of the invention. This is done merely for convenience and to give a general sense of the invention. This description should be read to include one or at least one and the singular also includes the plural unless it is obvious that it is meant otherwise.

Unless otherwise defined, all technical and scientific terms used herein have the same meaning as commonly understood by one of ordinary skill in the art to which this invention belongs. In the Formulae, the letters L, M, R, Y, and Z are used to designate atoms or groups which are defined within. All other letters are used to designate conventional atomic symbols.

Although methods and materials similar or equivalent to those described herein can be used in the practice or testing of the present invention, suitable methods and materials are described below. In case of conflict, the present specification, including definitions, will control. In addition, the materials, methods, and examples are illustrative only and not intended to be limiting.

### EXAMPLES

### Device Fabrication Procedure

A cleaned substrate of patterned indium tin oxide ("ITO") on glass was loaded into a vacuum chamber and the chamber was pumped down to 10⁻⁸ torr. The substrate was then further cleaned using an oxygen plasma for about 1-2 minutes. After cleaning, multiple layers of thin films were then deposited sequentially onto the substrate by thermal evaporation. Finally, patterned metal electrodes of Al were deposited through a mask. The thickness of the films were measured during deposition using a quartz crystal monitor. The completed OLED device was then taken out of the vacuum chamber and characterized immediately without encapsulation.

### Materials

"ZrQ₄" refers to the compound having Formula I, where M = Zr and all of a through h are zero: 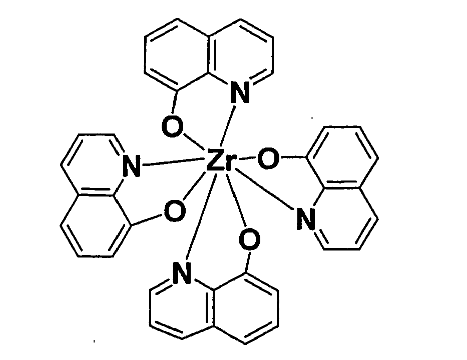 "Ir Compound 1" refers to the compound below, made according to the procedure in Example 10 of U.S. Patent 6,670,645: 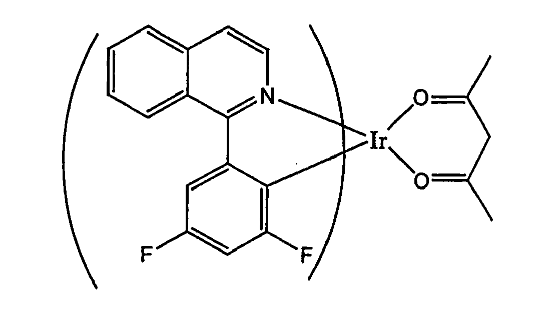 "mTDATA" refers to the compound: 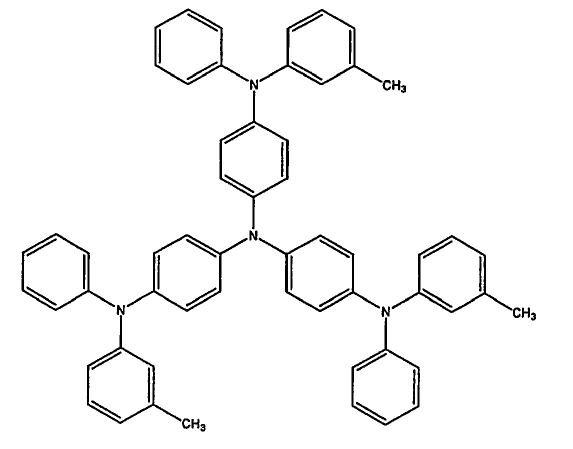 "NPB" refers to the compound:

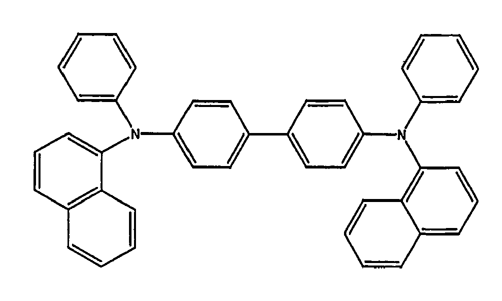

### Comparative Example

This comparative example illustrates a device in which the photoactive layer comprises a photoactive compound and a metal hydroxyquinoline complex, without a hole transport compound.

A device was made using the procedure described above, with following layers, where the layer thickness is given in parenthesis:
ITO (1000 Å)
MTDATA (800 Å)
7.4 vol% Ir Compound 1 in ZrQ₄ (443 A)
ZrQ₄ (307 Å)
LiF (11 Å)
Al (1004 Å)
Device performance results are summarized in Table I.

### Example 1

This example illustrates a device in which the photoactive layer comprises a photoactive compound (Ir Compound 1), a metal hydroxyquinoline complex (ZrQ₄), and a hole transport compound (NPB). A 1:1 (by weight) starting mixture of ZrQ₄ and NPB is used for deposition.

A device was made using the procedure described above, with following layers, where the layer thickness is given in parenthesis:
ITO (1000 Å)
MTDATA (808 Å)
7.5 vol% Ir compound 1 in ZrQ₄/NPB mixture (449 Å)
ZrQ4 (304 Å)
LiF(10 A)
Al(1005 Å)
Device performance results are summarized in Table I.

### Example 2

This example illustrates a device in which the photoactive layer comprises a photoactive compound (Ir Compound 1), a metal hydroxyquinoline complex (ZrQ₄), and a hole transport compound (mTDATA). A 1:1 (by weight) starting mixture of ZrQ₄ and mTDATA is used for deposition.

A device was made using the procedure described above, with following layers, where the layer thickness is given in parenthesis:
ITO (1000 Å)
mTDATA (805 Å)
7.5 vol% Ir compound 1 in ZrQ₄/mTDATA mixtures (449 A)
ZrQ₄ (305 A)
LiF(10 Å)
Al(1006 Å)
Device performance results are summarized in Table I.

From Table I, it can be seen that the devices having a photoactive layer comprising a photoactive compound, a metal hydroxyquinoline complex, and a hole transport compound, have an improved deeper red electroluminescence, higher current efficiency, and lower operation voltage.

**Table 1**

| Example | Comparative | Example 1 | Example 2 |
|---|---|---|---|
| Color coordinates | (0.641, 0.354) | (0.653,0.345) | (0.654, 0.345) |
| Efficiency, at 500 cd/m² | 5 cd/A | 10.8 cd/A | 9.4 cd/A |
| Operating voltage, at 500 cd/m² | 7.0V | 6.5V | 5.6 |

It is to be appreciated that certain features of the invention which are, for clarity, described above and below in the context of separate embodiments, may also be provided in combination in a single embodiment. Conversely, various features of the invention that are, for brevity, described in the context of a single embodiment, may also be provided separately or in any subcombination. Further, reference to values stated in ranges include each and every value within that range.

## Claims

1. A photoactive composition comprising a photoactive compound, a metal hydroxyquinoline complex, and a hole transport compound, wherein the photoactive composition is a liquid composition.

2. The composition of Claim 1, wherein the photoactive compound is an organometallic compound.

3. The composition of Claim 2, wherein the organometallic compound is a cyclometallated iridium complex.

4. The composition of Claim 3, wherein the iridium complex has a formula IrLᵢYⱼZₖ, where
L is a monoanionic bidentate ligand coordinated through a nitrogen on a heteroaromatic ring and a carbon,
Y is a monoanionic ligand,
Z is a neutral ligand, and
i, j, and k are selected from 0 and integers from 1-3, such that the iridium is hexacoordinate, and the overall complex is uncharged.

5. The composition of Claim 4, wherein L is selected from an arylheterocycle and a heteroarylheterocycle.

6. The composition of Claim 1, wherein the metal hydroxyquinoline complex has the formula: 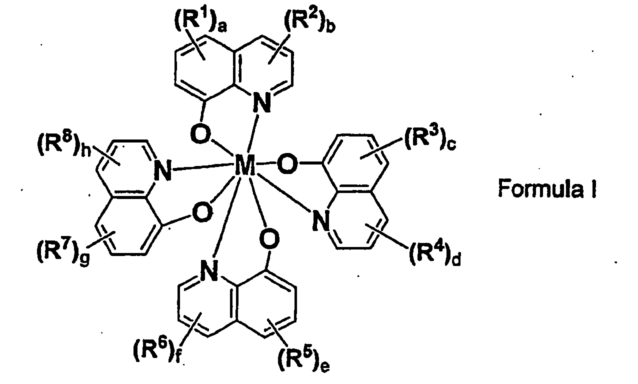 wherein:
M is selected from Ti, Zr, Hf, Nb, Re, Sn, and Ge,
R¹, R², R³, R⁴, R⁶, R⁶, R⁷, and R⁸ are each Independently deuterium, halo, nitrile, alkyl, aryl, alkoxy, aryloxy, fluoroalkyl, fluoroaryl, fluoroalkoxy, fluoroaryloxy, heteroalkyl, heteroaryl, heteroalkoxy, heteroaryloxy, or adjacent substitutents may be joined to form 5- or 6-membered aryl, heteroaryl, or cycloalkyl group; and
a, b, c, d, e, f, g, and h are each independently 0, 1, 2, or 3.

7. The composition of Claim 6, wherein a, b, c, d, e, f, g, and h are 0.

8. The composition of Claim 6, wherein at least one of R¹ through R⁸ is fluoro or fluoroalkyl.

9. The composition of Claim 1, wherein the hole transport compound is selected from 4,4',4"-tris(N,N-diphenyl-amino)-triphenylamine (TDATA); 4,4',4"-tris(N-3-methylphenyl-N-phenyl-amino)-triphenylamine (mTDATA); N,N'-diphenyl-N,N'-bis(3-methylphenyl)-[1,1'-biphenyl]-4,4'-diamine (TPD); 1,1-bis[(di-4-tolylamino) phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); α-phenyl-4-N,N-diphenylaminostyrene (TPS); p-(diethylamino)benzaldehyde diphenylhydrazone (DEH); triphenylamine (TPA); bis[4-(N,N-diethylamino)-2-methylphenyl](4-methylphenyl)methane (MPMP); 1-phenyl-3-[p-(diethylamino)styryl]-5-[p-(diethylamino)phenyl] pyrazoline (PPR or DEASP); 1,2-trans-bis(9H-carbazol-9-yl)cyclobutane (DCZB); N,N,N',N'-tetrakis(4-methylphenyl)-(1,1'-biphenyl)-4,4'-diamine (TTB); N,N'-bis(naphthalen-1-yl)-N,N'-bis-(phenyl)benzidine (α-NPB); and porphyrinic compounds.

10. An organic electronic device comprising an anode, a cathode, and a photoactive layer positioned therebetween, said photoactive layer contains a photoactive composition in the form of a film, said photoactive composition comprising a photoactive compound, a metal hydroxyquinoline complex, and a hole transport compound.

11. The device of Claim 10, wherein the photoactive compound is an organometallic compound.

12. The device of Claim 11, wherein the organometallic compound is a cyclometallated iridium complex.

13. The device of Claim 12, wherein the iridium complex has a formula IrLᵢYⱼZₖ, where
L is a monoanionic bidentate ligand coordinated through a nitrogen on a heteroaromatic ring and a carbon,
Y is a monoanionic ligand,
Z is a neutral ligand, and
i, J, and k are selected from 0 and integers from 1-3, such that the iridium is hexacoordinate, and the overall complex is uncharged.

14. The device of Claim 13, wherein L is selected from an arylheterocycle and a heteroarylheterocycle.

15. The device of Claim 10, wherein the metal hydroxyquinoline complex has the formula: 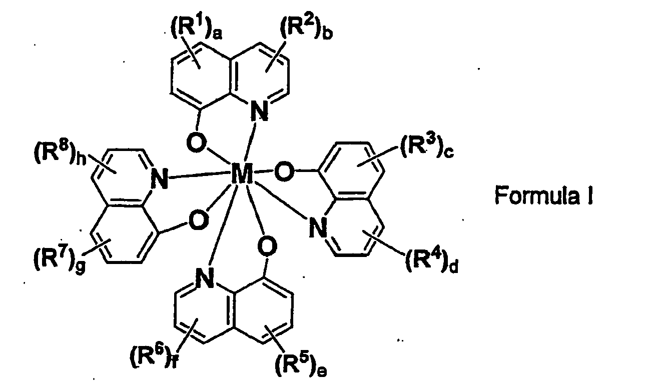 wherein:
M is selected from Ti, Zr, Hf, Nb, Re, Sn, and Ge,
R¹, R², R³, R⁴, R⁵, R⁶, R⁷, and R⁸ are each independently deuterium, halo, nitrile, alkyl, aryl, alkoxy, aryloxy, fluoroalkyl, fluoroaryl, fluoroalkoxy, fluoroaryloxy, heteroalkyl, heteroaryl, heteroalkoxy, heteroaryloxy, or adjacent substitutents may be joined to form 5- or 6-membered aryl, heteroaryl, or cycloalkyl group; and
a, b, c, d, e, f, g, and h are each independently 0, 1, 2, or 3.

16. The device of Claim 15, wherein a, b, c, d, e, f, g, and h are 0.

17. The device of Claim 15, wherein at least one of R¹ through R⁸ is fluoro or fluoroalkyl.

18. The device of Claim 10, wherein the hole transport compound is selected from 4,4',4"-tris(N,N-diphenyl-amino)-triphenylamine (TDATA); 4,4',4"-tris(N-3-methylphenyl-N-phenyl-amino)-triphenylamine (mTDATA); N,N'-diphenyl-N,N'-bis(3-methylphenyl)-[1.1'-biphenyl]-4,4'-diamine (TPD); 1,1-bis[(di-4-tolylamino) phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); α-phenyl-4-N,N-diphenylaminostyrene (TPS); p-(diethylamino)benzaldehyde diphenylhydrazone (DEH); triphenylamine (TPA); bis[4-(N,N-diethylamino)-2-methylphenyl](4-methylphenyl)methane (MPMP); 1-phenyl-3-[p-(diethylamino)styryl]-5-[p-(diethylamino)phenyl] pyrazoline (PPR or DEASP); 1,2-trans-bis(9H-carbazol-9-yl)cyclobutane (DCZB); N,N,N',N'-tetrakis(4-methylphenyl)-(1,1-biphenyl)-4,4'-diamine (TTB); N,N'-bis(naphthalen-1-yl)-N,N'-bis-(phenyl)benzidine (α-NPB); and porphyrinic compounds.

## Patentansprüche

1. Photoaktive Zusammensetzung, die eine photoaktive Verbindung, einen Metall-Hydroxychinolin-Komplex und eine Löchertransport-Verbindung aufweist, wobei die photoaktive Zusammensetzung eine flüssige Zusammensetzung ist.

2. Zusammensetzung nach Anspruch 1, wobei die photoaktive Verbindung eine metallorganische Verbindung ist.

3. Zusammensetzung nach Anspruch 2, wobei die metallorganische Verbindung ein cyclometallierter Iridiumkomplex ist.

4. Zusammensetzung nach Anspruch 3, wobei der Iridiumkomplex eine Formel IrLᵢYⱼZₖ aufweist, wobei
L ein monoanionischer zweizähniger Ligand ist, der über einen Stickstoff koordinativ an einen heteroaromatischen Ring und einen Kohlenstoff gebunden ist,
Y ein monoanionischer Ligand ist,
Z ein neutraler Ligand ist, und
i, j und k unter 0 und ganzen Zahlen von 1-3 so ausgewählt sind, dass das Iridium sechsfach koordinativ gebunden ist, und der Gesamtkomplex ungeladen ist.

5. Zusammensetzung nach Anspruch 4, wobei L unter einem Aryl-Heterocyclus und einem Heteroaryl-Heterocyclus ausgewählt ist.

6. Zusammensetzung nach Anspruch 1, wobei der Metall-Hydroxychinolin-Komplex die folgende Formel aufweist: 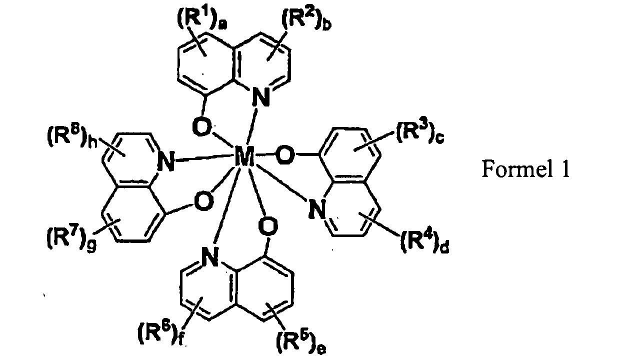 wobei:
M unter Ti, Zr, Hf, Nb, Re, Sn und Ge ausgewählt ist,
R¹, R², R³, R⁴, R⁵, R⁶, R⁷ und R⁸ jeweils unabhängig voneinander Deuterium, ein Halogen, Nitril, Alkyl, Aryl, Alkoxy, Aryloxy, Fluoralkyl, Fluoraryl, Fluoralkoxy, Fluoraryloxy, Heteroalkyl, Heteroaryl, Heteroalkoxy, Heteroaryloxy sind oder benachbarte Substituenten zu einer 5- oder 6-gliedrigen Aryl-, Heteroaryl- oder Cycloalkylgruppe verbunden sein können; und
a, b, c, d, e, f, g und h jeweils unabhängig voneinander gleich 0, 1, 2 oder 3 sind.

7. Zusammensetzung nach Anspruch 6, wobei a, b, c, d, e, f, g und h gleich 0 sind.

8. Zusammensetzung nach Anspruch 6, wobei mindestens eine der Gruppen R¹ bis R⁸ eine Fluor- oder Fluoralkylgruppe ist.

9. Zusammensetzung nach Anspruch 1, wobei die Löchertransport-Verbindung unter 4,4',4"-Tris(N,N-diphenylamino)triphenylamin (TDATA), 4,4',4"-Tris(N-3-methylphenyl-N-phenylamino)-triphenylamin (mTDATA); N,N'-Diphenyl-N,N'-bis(3-methylphenyl)-[1,1'-biphenyl]-4,4'-diamin (TPD); 1,1-Bis[(di-4-tolylamino)phenyl]cyclohexan (TAPC); N,N'-Bis(4-methylphenyl)-N,N'-bis(4-ethylphenyl)-[1,1'-(3,3'-dimethyl)biphenyl]-4,4'-diamin (ETPD); Tetrakis-(3-methylphenyl)-N,N,N',N'-2,5-phenylendiamin (PDA); α-Phenyl-4-N,N-diphenylaminostyrol (TPS); p-(Diethylamino)benzaldehyddiphenylhydrazon (DEH); Triphenylamin (TPA); Bis[4-(N,N-diethylamino)-2-methylphenyl](4-methylphenyl)methan (MPMP); 1-Phenyl-3-[p-(diethylamino)styryl]-5-[p-(diethylamino)phenyl]pyrazolin (PPR oder DEASP); 1,2-trans-Bis(9H-carbazol-9-yl)cyclobutan (DCZB); N,N,N',N'-Tetrakis(4-methylphenyl)-(1,1'-biphenyl)-4,4'-diamin (TTB); N,N'-Bis(naphthalin-1-yl)-N,N'-bis-(phenyl)benzidin (α-NPB) und porphyrinhaltigen Verbindungen ausgewählt ist.

10. Organisches elektronisches Bauelement, das eine Anode, eine Kathode und eine dazwischen angeordnete photoaktive Schicht aufweist, wobei die photoaktive Schicht eine photoaktive Zusammensetzung in Form eines Films enthält, wobei die photoaktive Zusammensetzung eine photoaktive Verbindung, einen Metall-Hydroxychinolin-Komplex und eine Löchertransport-Verbindung aufweist.

11. Bauelement nach Anspruch 10, wobei die photoaktive Verbindung eine metallorganische Verbindung ist.

12. Bauelement nach Anspruch 11, wobei die metallorganische Verbindung ein cyclometallierter Iridiumkomplex ist.

13. Bauelement nach Anspruch 12, wobei der Iridiumkomplex eine Formel IrLᵢYⱼZₖ aufweist, wobei
L ein monoanionischer zweizähniger Ligand ist, der über einen Stickstoff koordinativ an einen heteroaromatischen Ring und einen Kohlenstoff gebunden ist,
Y ein monoanionischer Ligand ist,
Z ein neutraler Ligand ist, und
i, j und k unter 0 und ganzen Zahlen von 1-3 so ausgewählt sind, dass das Iridium sechsfach koordinativ gebunden ist, und der Gesamtkomplex ungeladen ist.

14. Bauelement nach Anspruch 13, wobei L unter einem Aryl-Heterocyclus und einem Heteroaryl-Heterocyclus ausgewählt ist.

15. Bauelement nach Anspruch 10, wobei der Metall-Hydroxychinolin-Komplex die folgende Formel aufweist: 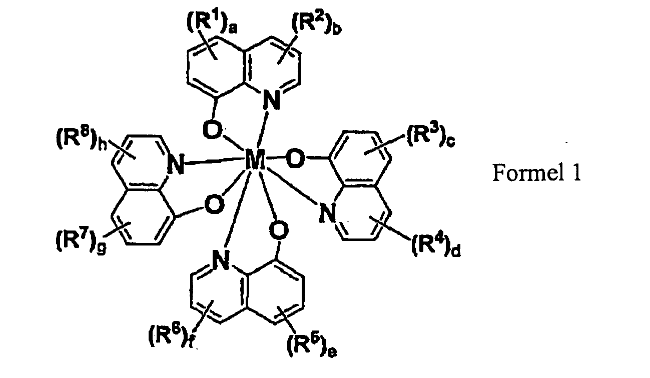 wobei:
M unter Ti, Zr, Hf, Nb, Re, Sn und Ge ausgewählt ist,
R¹, R², R³, R⁴, R⁵, R⁶, R⁷ und R⁸ jeweils unabhängig voneinander Deuterium, ein Halogen, Nitril, Alkyl, Aryl, Alkoxy, Aryloxy, Fluoralkyl, Fluoraryl, Fluoralkoxy, Fluoraryloxy, Heteroalkyl, Heteroaryl, Heteroalkoxy, Heteroaryloxy sind oder benachbarte Substituenten zu einer 5- oder 6-gliedrigen Aryl-, Heteroaryl- oder Cycloalkylgruppe verbunden sein können; und
a, b, c, d, e, f, g und h jeweils unabhängig voneinander gleich 0, 1, 2 oder 3 sind.

16. Bauelement nach Anspruch 15, wobei a, b, c, d, e, f, g und h gleich 0 sind.

17. Bauelement nach Anspruch 15, wobei mindestens eine der Gruppen R¹ bis R⁸ eine Fluor- oder Fluoralkylgruppe ist.

18. Bauelement nach Anspruch 10, wobei die Löchertransport-Verbindung unter 4,4',4"-Tris(N,N-diphenylamino)triphenylamin (TDATA), 4,4',4"-Tris(N-3-methylphenyl-N-phenylamino)-triphenylamin (mTDATA); N,N'-Diphenyl-N,N'-bis(3-methylphenyl)-[1,1'-biphenyl]-4,4'-diamin (TPD); 1,1-Bis[(di-4-tolylamino)phenyl]cyclohexan (TAPC); N,N'-Bis(4-methylphenyl)-N,N'-bis(4-ethylphenyl)-[1,1'-(3,3'-dimethyl)biphenyl]-4,4'-diamin (ETPD); Tetrakis-(3-methylphenyl)-N,N,N',N'-2,5-phenylendiamin (PDA); α-Phenyl-4-N,N-diphenylaminostyrol (TPS); p-(Diethylamino)benzaldehyddiphenylhydrazon (DEH); Triphenylamin (TPA); Bis[4-(N,N-diethylamino)-2-methylphenyl](4-methylphenyl)methan (MPMP); 1-Phenyl-3-[p-(diethylamino)styryl]-5-[p-(diethylamino)phenyl]pyrazolin (PPR oder DEASP); 1,2-trans-Bis(9H-carbazol-9-yl)cyclobutan (DCZB); N,N,N',N'-Tetrakis(4-methylphenyl)-(1,1'-biphenyl)-4,4'-diamin (TTB); N,N'-Bis(naphthalin-1-yl)-N,N'-bis-(phenyl)benzidin (α-NPB) und porphyrinhaltigen Verbindungen ausgewählt ist.

## Revendications

1. Composition photoactive comprenant un composé photoactif, un complexe métallique hydroxyquinoléine, et un composé de transport de trous, la composition photoactive étant une composition liquide.

2. Composition selon la revendication 1, dans laquelle le composé photoactif est un composé organométallique.

3. Composition selon la revendication 2, dans laquelle le composé organométallique est un complexe d'iridium cyclométallaté.

4. Composition selon la revendication 3, dans laquelle le complexe d'iridium a une formule IrLᵢYⱼZₖ, où
L est un ligand bidenté monoanionique coordonné à travers un atome d'azote sur un cycle hétéroaromatique et un atome de carbone,
Y est un ligand monoanionique,
Z est un ligand neutre, et
i, j, et k sont choisis parmi 0 et les nombres entiers de 1 à 3, de sorte que l'iridium soit hexacoordonné et que le complexe global soit non chargé.

5. Composition selon la revendication 4, dans laquelle L est choisi parmi un hétérocycle arylique et un hétérocycle hétéroarylique.

6. Composition selon la revendication 1, dans laquelle le complexe métallique hydroxyquinoléine a la formule: 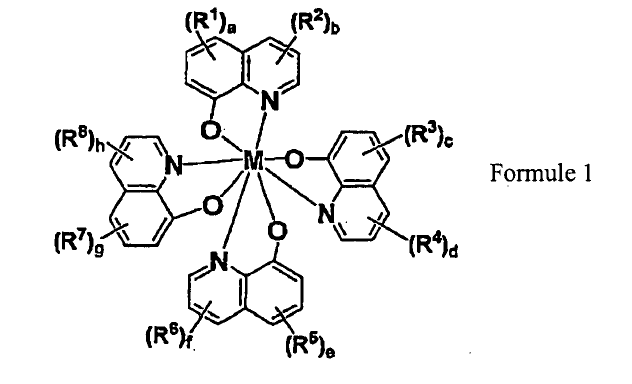 dans laquelle:
M est choisi parmi Ti, Zr, Hf, Nb, Re, Sn, et Ge,
R¹, R², R³, R⁴, R⁵, R⁶, R⁷, et R⁸ sont chacun indépendamment du deutérium, un groupe halogéno, nitrile, alkyle, aryle, alcoxy, aryloxy, fluoroalkyle, fluoroaryle, fluoroalcoxy, fluoroaryloxy, hétéroalkyle, hétéroaryle, hétéroalcoxy, hétéroaryloxy, ou les substituants adjacents peuvent être joints pour former un groupe aryle, hétéroaryle, ou cycloalkyle à 5 ou 6 chaînons; et
a, b, c, d, e, f, g, et h sont chacun indépendamment 0, 1, 2, ou 3.

7. Composition selon la revendication 6, dans laquelle a, b, c, d, e, f, g, et h ont la valeur de 0.

8. Composition selon la revendication 6, dans laquelle au moins l'un de R¹ à R⁸ est un groupe fluoro ou fluoroalkyle.

9. Composition selon la revendication 1, dans laquelle le composé de transport de trous est choisi parmi la 4,4',4"-tris(N,N-diphényl-amino)-triphénylamine (TDATA); la 4,4',4"-tris(N-3-méthylphényl-N-phényl-amino)-triphénylamine (mTDATA); la N,N'-diphényl-N,N'-bis(3-méthylphényl)-[1,1'-biphényl]-4,4'-diamine (TPD); le 1,1-bis[(di-4-tolylamino)phényl]cyclohexane (TAPC); la N,N'-bis(4-méthylphényl)-N,N'-bis(4-éthylphényl)-[1,1,-(3,3'-diméthyl)biphényl]-4,4'-diamine (ETPD); la tétrakis-(3-méthylphényl)-N,N,N',N'-2,5-phénylènediamine (PDA); 1'α-phényl-4-N,N-diphénylaminostyrène (TPS); le p-(diéthylamino)benzaldéhyde-diphénylhydrazone (DEH); la triphénylamine (TPA); le bis[4-(N,N-diéthylamino)-2-méthylphényl](4-méthylphényl)méthane (MPMP); la 1-phényl-3-[p-(diéthylamino)styryl]-5-[p-(diéthylamino)phényl]pyrazoline (PPR ou DEASP); le 1,2-trans-bis(9H-carbazol-9-yl)cyclobutane (DCZB); la N,N,N',N'-tétrakis(4-méthylphényl)-(1,1'-biphényl)-4,4'-diamine (TTB); la N,N'-bis(naphtalèn-1-yl)-N,N'-bis-(phényl)benzidine (α-NPB); et les composés porphyriniques.

10. Dispositif électronique organique comprenant une anode, une cathode, et une couche photoactive positionnée entre elles, ladite couche photoactive contient une composition photoactive sous la forme d'un film, ladite composition photoactive comprenant un composé photoactif, un complexe métallique hydroxyquinoléine, et un composé de transport de trous.

11. Dispositif selon la revendication 10, dans lequel le composé photoactif est un composé organométallique.

12. Dispositif selon la revendication 11, dans lequel le composé organométallique est un complexe cyclométallaté d'iridium.

13. Dispositif selon la revendication 12, dans lequel le complexe d'iridium a une formule IrLᵢYⱼZₖ, où
L est un ligand bidenté monoanionique coordonné par un atome d'azote sur un cycle hétéroaromatique et un atome de carbone,
Y est un ligand monoanionique,
Z est un ligand neutre, et
i, j, et k sont choisis parmi 0 et les nombres entiers de 1 à 3, de sorte que l'iridium soit hexacoordonné, et que le complexe global soit non chargé.

14. Dispositif selon la revendication 13, dans lequel L est choisi parmi un hétérocycle arylique et un hétérocycle hétéroarylique.

15. Dispositif selon la revendication 10, dans lequel le complexe métallique hydroxyquinoléine a la formule: 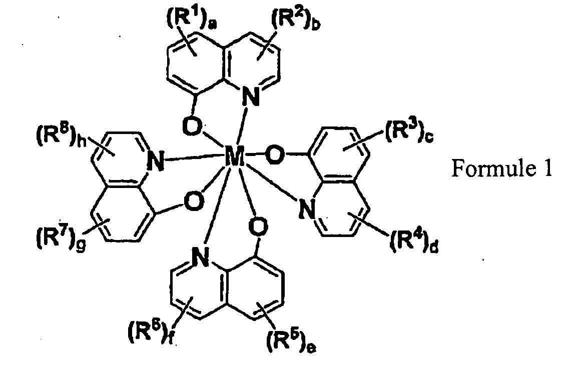 dans laquelle:
M est choisi parmi Ti, Zr, Hf, Nb, Re, Sn, et Ge,
R¹, R², R³, R⁴, R⁵, R⁶, R⁷, et R⁸ sont chacun indépendamment du deutérium, un groupe halogéno, nitrile, alkyle, aryle, alcoxy, aryloxy, fluoroalkyle, fluoroaryle, fluoroalcoxy, fluoroaryloxy, hétéroalkyle, hétéroaryle, hétéroalcoxy, hétéroaryloxy, ou des substituants adjacents peuvent être joints pour former un groupe aryle, hétéroaryle, ou cycloalkyle à 5 ou 6 chaînons; et
a, b, c, d, e, f, g, et h sont chacun indépendamment 0, 1, 2, ou 3.

16. Dispositif selon la revendication 15, dans lequel a, b, c, d, e, f, g, et h ont la valeur de 0.

17. Dispositif selon la revendication 15, dans lequel au moins un parmi R¹ à R⁸ est un groupe fluoro ou fluoroalkyle.

18. Dispositif selon la revendication 10, dans lequel le composé de transport de trous est choisi parmi la 4,4',4"-tris(N,N-diphényl-amino)-triphénylamine (TDATA); la 4,4',4"-tris(N-3-méthylphényl-N-phényl-amino)-triphénylamine (mTDATA); la N,N'-diphényl-N,N'-bis(3-méthylphényl)-[1,1'-biphényl]-4,4'-diamine (TPD); le 1,1-bis[(di-4-tolylamino)phényl]cyclohexane (TAPC); la N,N'-bis(4-méthylphényl)-N,N'-bis(4-éthylphényl)-[1,1'-(3,3'-diméthyl)biphényl]-4,4'-diamine (ETPD); la tétrakis-(3-méthylphényl)-N,N,N',N'-2,5-phénylènediamine (PDA); l'a-phényl-4-N,N-diphénylaminostyrène (TPS); le p-(diéthylamino)benzaldéhyde-diphénylhydrazone (DEH); la triphénylamine (TPA); le bis[4-(N,N-diéthylamino)-2-méthylphényl](4-méthylphényl)méthane (MPMP); la 1-phényl-3-[p-(diéthylamino)styryl]-5-[p-(diéthylamino)phényl]pyrazoline (PPR ou DEASP); le 1,2-trans-bis(9H-carbazol-9-yl)cyclobutane (DCZB); la N,N,N',N'-tétrakis(4-méthylphényl)-(1,1'-biphényl)-4,4'-diamine (TTB); la N,N'-bis(naphtalèn-1-yl)-N,N'-bis-(phényl)benzidine (α-NPB); et les composés porphyriniques.
